**Europäisches Patentamt**

**European Patent Office**

**Office européen des brevets**

(11) Veröffentlichungsnummer: **0 210 560**
**A2**

## EUROPÄISCHE PATENTANMELDUNG

(21) Anmeldenummer: 86109933.1

(22) Anmeldetag: 19.07.86

(51) Int. Cl.⁴: **H 05 K 3/34**
**H 05 K 1/18**

(30) Priorität: 27.07.85 DE 3527043

(43) Veröffentlichungstag der Anmeldung:
04.02.87 Patentblatt 87/6

(84) Benannte Vertragsstaaten:
BE DE FR GB IT NL

(71) Anmelder: GRUNDIG E.M.V. Elektro-Mechanische
Versuchsanstalt Max Grundig holländ. Stiftung & Co. KG.
Kurgartenstrasse 37
D-8510 Fürth(DE)

(72) Erfinder: Bärmann, Dieter, Dipl.-Ing.
Am Buch 1 A
D-8562 Hersbruck(DE)

(54) Verfahren zum Einlöten einer integrierten Schaltung in eine Leiterplatte.

(57) Beschrieben wird ein Verfahren zum Einlöten einer integrierten Schaltung mit federnden Anschlußkontakten in eine Leiterplatte. Die integrierte Schaltung wird klemmend in einen Ausschnitt einer Leiterplatte eingesetzt, und die Anschlußkontakte werden mit den Leiterbahnen nach für die Massenfertigung gebräuchlichen Lötverfahren (Schwallbadlötung) verlötet.

FIG. 2

Λ

# VERFAHREN ZUM EINLÖTEN EINER INTEGRIERTEN SCHALTUNG IN EINE LEITERPLATTE

## BESCHREIBUNG

Es ist bekannt, daß integrierte Schaltungen in rechteckiger Bauform über feststehende Anschlußstifte in entsprechende Bohrungen einer Leiterplatte eingesteckt, und mit den zugeordneten Leiterbahnen der Leiterplatte verlötet werden. Es sind nun auch integrierte Schaltungen unter der gebräuchlichen Bezeichnung PCC (plastic chip carrier) bekannt, deren Kunststoffgehäuse an den Umfangsseiten federnde Kontakte aufweisen, und die mittels eines aufwendigen Kontaktsockels auf eine Leiterplatte aufgesteckt werden. Der Sockel wird mittels fester Lötstifte nach bekannten Lötverfahren (z. B. Tauchlötung) auf die Leiterplatte aufgelötet. Ein direktes Auflöten eines PCC-Bausteins auf die Leiterbahnseite der Leiterplatte ist nur mit besonders aufwendigen Löteinrichtungen über eine an den speziellen Lötpunkten im Druckverfahren aufgebrachte Lötpaste möglich.

Die Verwendung eines derartigen Bausteins ist deshalb aus Kostengründen nicht in allen Geräten vertretbar.

Aufgabe der Erfindung ist es daher, ein Verfahren zum Einlöten eines PCC-Bausteins zu finden, das es ermöglicht, den Baustein bei Anwendung einfacher und bekannter Lötverfahren (Schwallbadlötung) und ohne Verwendung eines zusätzlichen Lötsockels mit einer Leiterplatte direkt und einschließlich anderer noch auf der Leiterplatte befindlichen Bauteile zu verlöten.

Diese Aufgabe wird erfindungsgemäß durch die im Kennzeichen des Patentanspruchs 1 angegebenen Merkmale gelöst.

Die Erfindung wird nachfolgend anhand der Zeichnungen erläutert.

Fig. 1     ist eine vereinfachte Draufsicht
           auf eine Leiterplatte mit einem
           eingelöteten PCC-Baustein,

Fig. 2     ist ein Teilschnitt durch die
           Leiterplatte nach Fig. 1 in Seitenansicht, und

Fig. 3     ist eine vergrößerte Darstellung
           einer Einzelheit  III aus der Fig.2.

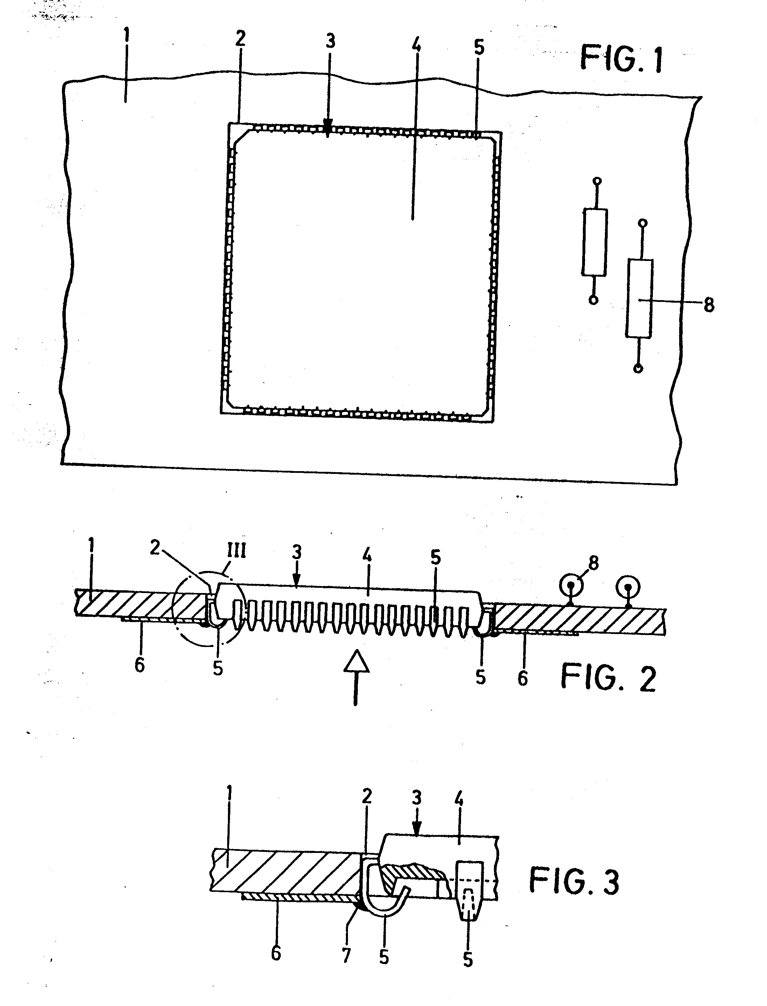

Die Figur 1 zeigt eine Leiterplatte 1 mit einem rechteckigen Ausschnitt 2, in den eine integrierte Schaltung 3 eingesetzt und mit den zugeordneten Leiterbahnen der Leiterplatte verlötet ist. Die integrierte Schaltung 3 weist ein rechteckiges Kunststoffgehäuse 4 mit an den Umfangsseiten angeordneten federnden Kontakten 5 auf. In der dargestellten Zeichnung befinden sich die Lötbahnen auf der nicht sichtbaren unteren Seite der Leiterplatte. Auf der Leiterplatte befinden sich ferner noch diverse andere Bauteile 8.

Aus der Figur 2 ist ersichtlich, wie die integrierte Schaltung in Pfeilrichtung von der Leiterbahnseite her in den Ausschnitt 2 der Leiterplatte 1 eingedrückt und die Kontakte 5 der integrierten Schaltung mit den Leiterbahnen 6 der Leiterplatte verlötet ist.

Der Ausschnitt 2 in der Leiterplatte 1 ist so gewählt, daß sich die integrierte Schaltung 3 durch ein bestimmtes Verbiegen der federnden Kontakte im Ausschnitt festklemmt und ohne zusätzliche Halterung durch das Lötbad geschickt werden kann.

Die Figur 3 zeigt eine Einzelheit III der Figur 2, wobei die Anlage eines federnden Kontaktes 5 der integrierten Schaltung 3 an eine Wand des Ausschnitts 2 in der Leiterplatte 1 vergrößert dargestellt ist.

4

Weiterhin ist in der dargestellten Zeichnung zu erkennen, in welchem Bereich die federnden Kontakte 5
der integrierten Schaltung 3 mit den Leiterbahnen 6
der Leiterplatte 1 über eine Lötstelle 7 verbunden
sind.

VERFAHREN ZUM EINLÖTEN EINER INTEGRIERTEN
SCHALTUNG IN EINE LEITERPLATTE


PATENTANSPRÜCHE


1. Verfahren zum Einlöten einer integrierten
Schaltung in eine Leiterplatte, wobei die integrierte
Schaltung (3) ein rechteckiges Kunststoffgehäuse mit
an den Umfangsseiten federnd angeordneten Kontakten
aufweist, d a d u r c h   g e k e n n z e i c h -
n e t ,   daß

a) ein rechteckiger Ausschnitt (2) in eine
   Leiterplatte (1) eingestanzt wird,

b) der Ausschnitt (2) kleiner als die äußeren
   Abmessungen des Kunststoffgehäuses (3,4,5)
   einschließlich der federnden Kontakte (5) ausgeführt wird,

2

c) die integrierte Schaltung (3) klemmend und
   von der Lötseite her bündig in den Ausschnitt
   (2) der Leiterplatte (1) gedrückt wird,und

d) die Kontakte (5) der integrierten Schaltung
   (3) mit den zugeordneten Leiterbahnen (6) der
   Leiterplatte (1) gemeinsam nach einem der
   bekannten Lötverfahren verlötet wird.

2. Verfahren nach Anspruch 1,   d a d u r c h
g e k e n n z e i c h n e t ,   daß als Lötverfahren
eine Schwallbadlötung verwendet wird.

# FIG. 1

# FIG. 2

# FIG. 3